# EUROPEAN PATENT SPECIFICATION

(11) **EP 2 836 057 B1**
(45) Date of publication and mention of the grant of the patent: **17.07.2019**
(21) Application number: 13250091.9
(22) Date of filing: 09.08.2013
(51) Int. Cl.: H05K 5/02, H05K 7/20

(54) **Ventilation system**
Belüftungssystem
Système de ventilation

(43) Date of publication of application: 11.02.2015
(73) Proprietor: British Telecommunications public limited company, London EC1A 7AJ (GB)
(72) Inventor: WARREN, John, Andrew, EC1A 7AJ London (GB)
(74) Representative: British Telecommunications public limited company Intellectual Property Department

(56) References cited:
- US-A1- 2008 112 129
- US-A1- 2011 174 402
- US-A1- 2012 125 681

## Description

The present invention relates to equipment cabinets of the kind used in outdoor locations to house electrical equipment such as telecommunications connection points. The equipment cabinets are provided primarily in order to protect the equipment from the weather, but also to prevent unauthorised interference. A typical telecommunications cubicle is designed to hold a number of line cards (typically between four and six), each having 48 or 64 ports The ports may be simple electrical connections but in modern "fibre to the cabinet" installations are the interface between the network-side optical fibre network and the "legacy" electrical connections to individual customer premises, and thus include optical/electrical transducers.

Each line card generates a significant amount of heat, typically 100W-150W. In addition typical maximum solar gain in the United Kingdom is between 10C - 15C. The ventilation arrangements for a standard roadside cabinet are designed to maintain the temperature within working limits when the maximum number of line cards are present. Consequently, the cabinets require a ventilation system with louvres suitably sized in order to maintain the temperature inside the cabinet within the working limits of the equipment housed therein. In many environments, a thermostatically controlled electric fan is also provided to augment the natural ventilation. The ventilation system is, of course, optimised for the climatic conditions of the location at which the cabinet is to be installed.

It is common practice to install a cabinet that is bigger than is necessary to meet the immediate requirement, in anticipation that additional line cards can be readily installed, or dormant ones brought into use, as local demand for the services available through that cabinet increases. Consequently, if the cabinet has fewer line cards installed than the number for which it is designed, less heat will be generated. This results in temperatures being too low if fewer cards have been installed. In cold weather, the heat from the few line cards installed or commissioned may not be sufficient to prevent condensation, which could damage the electronic equipment inside the cubicle, as cold moist air enters through the louvres.

It is therefore desirable to adapt the ventilation system according to the amount of equipment installed. This could be done by designing the natural ventilation for the minimum case, when there are few or no heat sources in the cabinet, but this the requires more artificial ventilation when the cabinet is operating at more than this minimum load. Such over-reliance on artificial ventilation consumes more power, and is also less reliable as there is more wear and tear on the fan, and a failure is more likely to result in overheating and damage to the equipment. Another alternative would be to provide natural ventilation suitable for the maximum load, and when the cabinet is only in partial use to provide artificial heating in cold weather to prevent condensation, but again this requires extra power and is vulnerable to electrical failure.

A further alternative would be to modify the ventilation characteristics as new equipment is installed or commissioned, for example by installing a bigger fan, or by replacing a panel of the housing by a panel with more, or bigger, louvres. However, this requires the technician installing or commissioning the new equipment to have brought with him the components necessary to effect such modification, and makes the tasks of both installation and stock control more complex.

United States Patent Applications US2012/125681, US2008/112129 and US2011/174402 describe a further approach using sliding shutters to adjust the size of ventilation apertures. However, the correct amount of ventilation may be difficult to determine, and the shutters may be tampered with.

The present invention provides a method for controlling the ventilation characteristics of an equipment cubicle, the cubicle comprising a housing enclosing an interior space, and the housing having one or more apertures for ventilation of the interior space, wherein the interior space of the cabinet has provision for installation of a plurality of electrical components,
characterised in that the method comprises the installation, within the cubicle, of a baffle comprising a plurality of detachable leaves masking at least a part of the apertures, and wherein a number of leaves are detached from the baffle in accordance with the number of electrical components installed.

This reduces the range of temperatures over which the rest of the cabinet is required to be capable of operation, without requiring any additional moving parts, by adjusting the ventilation characteristics of the cabinet simply by removing one or more of the leaves of the baffle by the technician installing or commissioning the new equipment.

Preferably, the detachable leaves are connected to each other by frangible webs. The baffle may be designed such that individual leaves can, when required, be readily removed by any suitable means, for example by snapping them off a frame or sprue connecting them together, and discarding them.

Typically, a cabinet with capacity for five line cards could be provided with a baffle with four leaves when installed with a first line card, one leaf being detached each time an additional line card is added, so as to maintain a specified minimum operating temperature. Local weather conditions, or records of high or low temperature events recorded by monitoring equipment in the cabinet, may be used to inform a decision as to whether to remove more or fewer plates.

Depending on the design of the cabinet, it may be possible to arrange that the additional equipment can only be installed if a corresponding baffle plate is removed. For example, they could occupy overlapping spaces in the cabinet, or the presence of the baffle plate may be such as to prevent access to an electrical connection.

The configuration of the individual leaves will depend on the internal space available in the cubicle and the ventilation characteristics required. For example, they may be arranged in a coplanar configuration, or overlying each other.

The detailed design of baffle will depend on the interior space available in the cubicle, and preferably, the baffle comprises means for securing it to an interior component of the equipment cubicle, in such a way that the cubicle itself does not require any modification to accommodate the baffle. This allows existing cubicle designs to have baffles installed according to the method of the invention, increasing the range of environmental conditions and installed equipment with which each cubicle design can be used.

Embodiments of thje invnetion will now be described, by way of example, and with reference to the Figures, in which:
Figure 1 is an external view of a typical equipment cubicle of the kind to which the invention may be applied
Figure 2 is a view of the equipment cubicle of Figure 1, with an access door in its open position to reveal its interior
Figure 3 depicts a first embodiment of a baffle for use in the invention
Figure 3a depicts a variant of the first embodiment
Figure 4 depicts the baffle of Figure 3 installed in the access door of the equipment cubicle of Figure 2, with one leaf of the baffle being removed
Figure 5 depicts a second embodiment of a baffle for use in the invention
Figure 6 depicts the baffle of Figure 5 installed in the access door of the equipment cubicle of Figure 2
Figure 7 depicts the baffle of Figure 5 installed in the access door of the equipment cubicle of Figure 2, with three leaves of the baffle removed
Figure 8 depicts a third embodiment of a baffle for use in the invention
Figure 9 depicts the baffle of Figure 8 installed in the access door of the equipment cubicle of Figure 2
Figure 10 depicts the baffle of Figure 8 installed in the access door of the equipment cubicle of Figure 2, with two leaves of the baffle removed

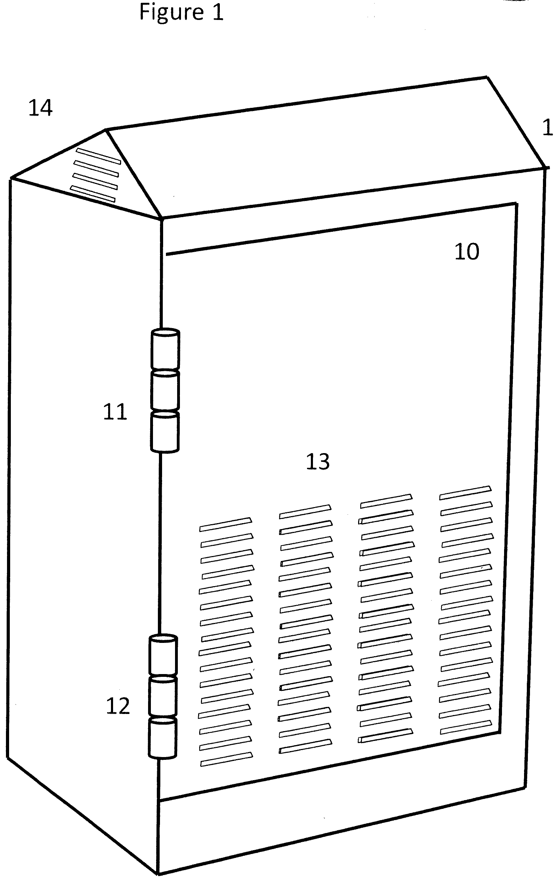

In Figure 1, is a schematic representation of the exterior of an existing design of equipment cubicle 1. The cubicle includes an access door 10 mounted on hinges 11, 12 and has a number of ventilatoin louvres 13, 14. When a new cubicle is to be installed, a suitably sized cubicle can be selected with the number and size of the louvres appropriate to the expected operating conditions, and in particular the local climate. However, once a cubicle is in use it would be difficult to adapt these features should the operating conditions change, and in particular if additional equipment, which may generate more heat, is expected to be installed within the cubicle at some time after initial deployment

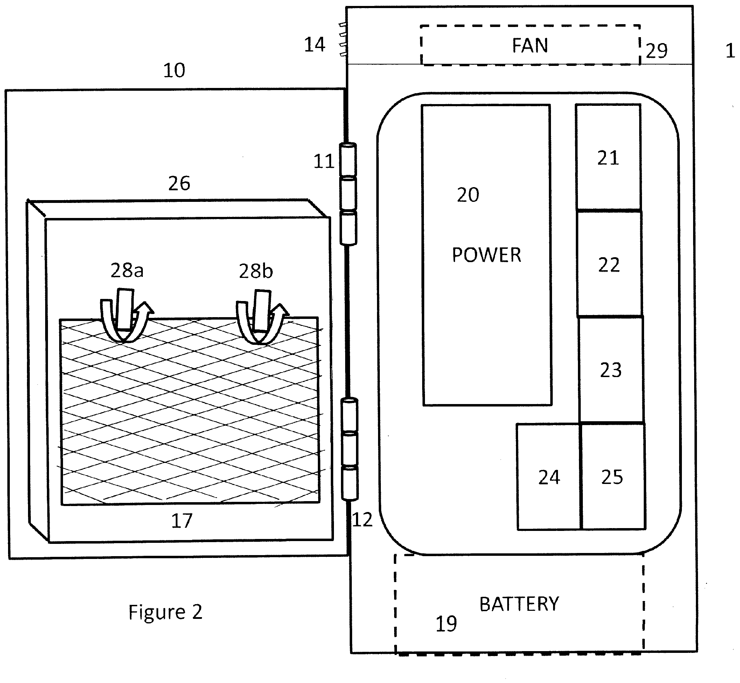

Figure 2 is a schematic illustration of the cubicle 1 with the access door 10 open to reveal certain interior components. Certain components 19, 29 are depicted in dotted lines as they are partially hidden by the exterior panelling.

The interior components include a power management system 20 and a backup battery 19, slots 21-25 for respective line cards, and a ventilation system mounted on the inside face of the access door 10 and comprising a filter housing 26, having a mesh grille 27 secured by catches 28a, 28b and communicating with the louvres 13. An electric fan 29 is installed to assist natural ventilation.

The ventilation system 13, 14, 26, 27, 29 is designed to maintain the operating temperature within the cubicle 1 within the safe working range of the line cards 21-25.However, as the line cards themselves generate a significant amount of heat, typically 100-150W each, the amount of heat within the cubicle depends to a significant extent on how many line cards are in use. The ventilation system has to be designed to maintain the temperture below the safe maximum even when all the cards are in use, whilst avoiding excessive ventilation in cold moist conditions which could result in condensation building up on the electrical components, causing potential damage.

The cubicle could be arranged to have only minimal natural ventilation, so that forced ventilation is required in nearly all circumstances, but this is expensive to operate and depends on the reliability of the fans. It would also be possible to provide heaters to substitute for any absent line cards 22, 23, 24, 25 when the cubicle is only partially in use, but this again requires additional power.

The present invention provides an alternative method, by installing a baffle plate to reduce the natural ventilation when not all line cards 21, 22, 23, 24, 25 are in use. Typically, the number of leaves in the baffle plate 30 would be one less than he maxiumum number of line cards that can be fitted in the cubicle. If only one line card 21 is in use, the complete plate is installed, and one leaf is then removed for each additional line card 22, 23 etc added.

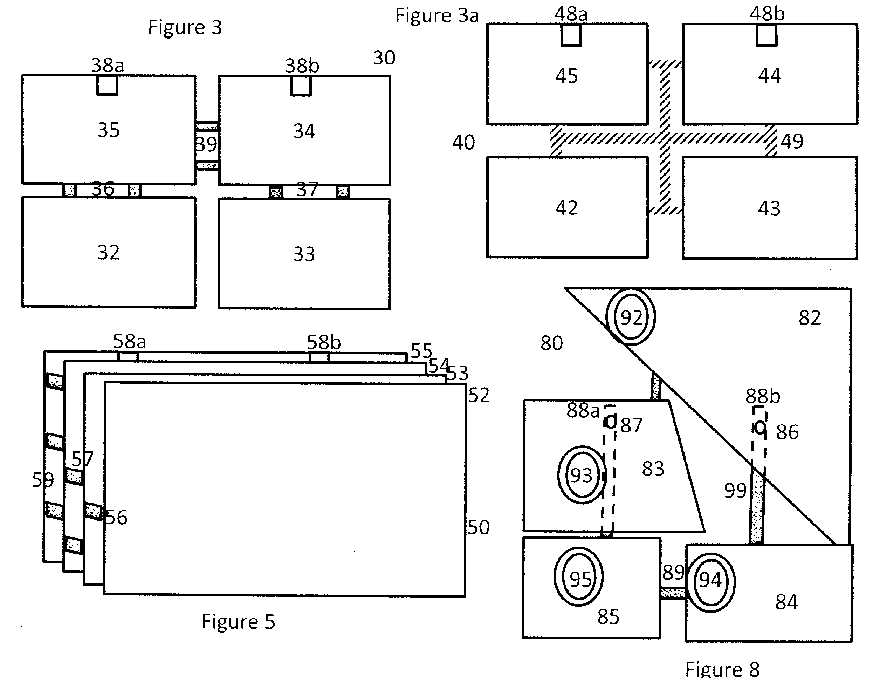

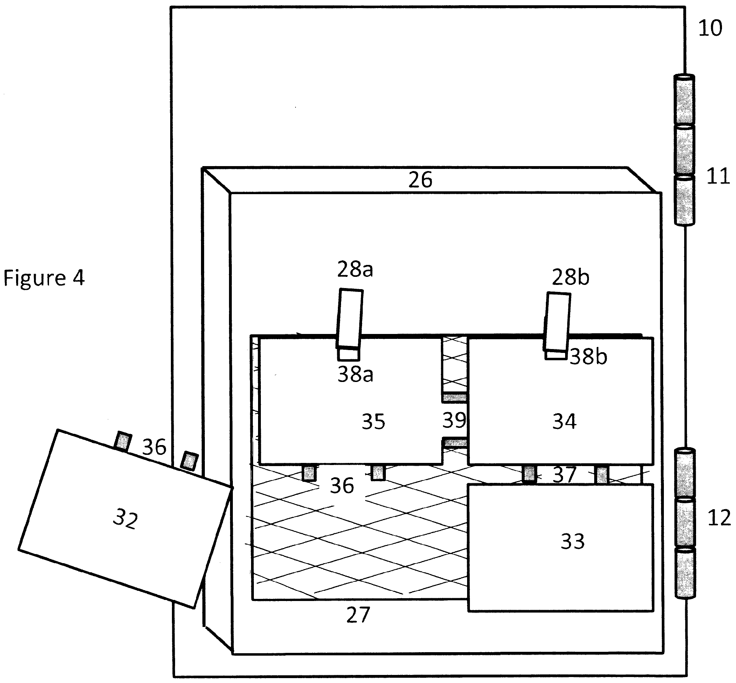

Figures 3, 3a, 5 and 8 illustrate four possible designs of baffle plate, and Figures 4, 6, 7, 9 and 10 are views of the inside of the door 10 of the cubicle 1 (comparable with the left hand side of Figure 2), with these baffle plates installed in various configurations.

Considering firstly Figures 3 and 4, the plate 30 comprises four coplanar leaves 32, 33, 34, 35 in a square configuration and connected together by frangible webs or sprues 36. The plate also includes two detents 38a, 38b, of suitable position and size to engage with the catches 28a, 28b securing the mesh grille 27 to the filter housing 26 in the door 10 of the cubicle 1.

In Figure 3a the plate 40 comprises four coplanar leaves 42, 43, 44, 45 in a square configuration, each connected to a sprue or framework 39 from which the individual leaves can be removed as required. As in Figure 3, the plate also includes two detents 48a, 48b, of suitable position and size to engage with the catches 28a; 28b securing the mesh grille 27 to the filter housing 26 in the door 10 of the cubicle 1.

Figure 4 shows the plate 30 of Figure 3 installed, and with one of the leaves 32 removed by breaking the frangible web 36 connecting it to the rest of the plate so that only three leaves 33, 34, 35 remain.

The baffle plate 30 acts to reduce the ingress of cold moist air to a level that can be evaporated by the smaller number of line cards 21, 22, etc installed. As more cards are installed, leaves 32, 33 etc are removed from the baffle plate to increase ventilation, allowing a smaller fan 29 to be used, and/or to be used less often, han would be the case if ventilation remaoined optimised for the smaller number of line cards.

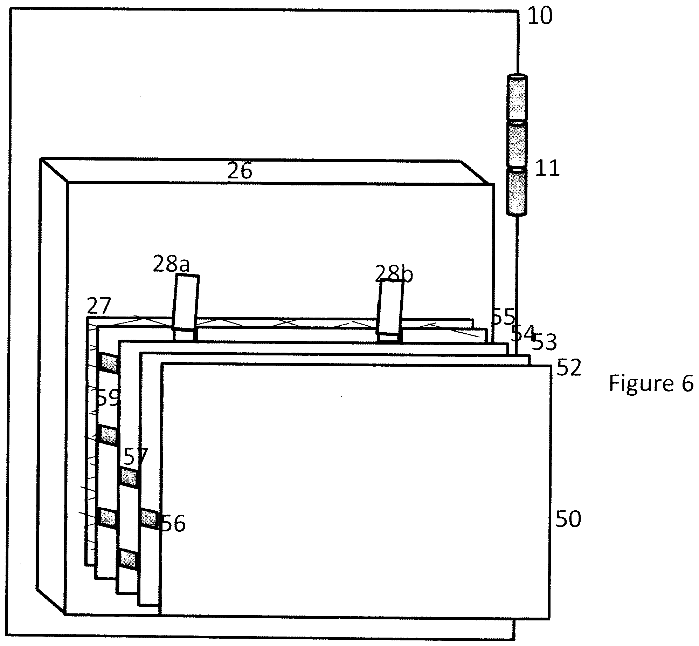

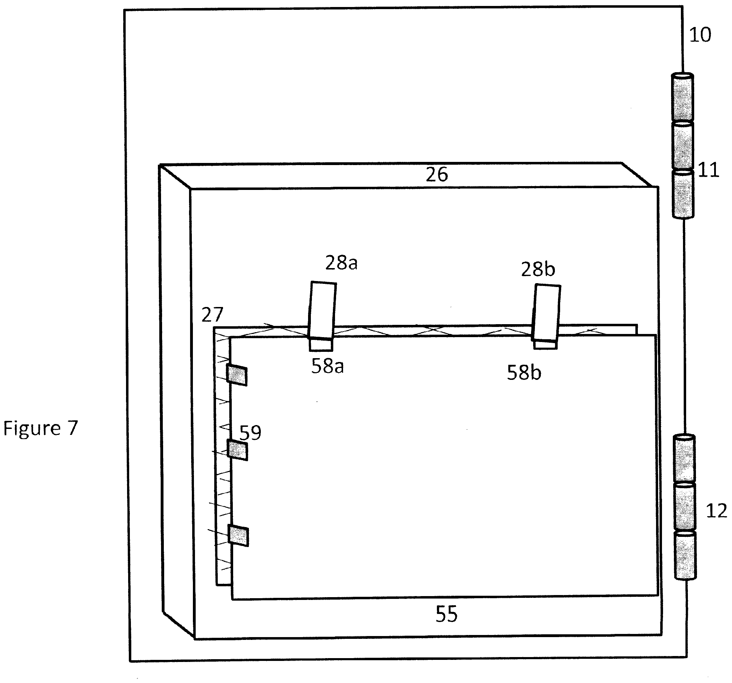

Figure 5 depicts a second design of baffle, which is shown in Figure 6 and Figure 7 in its installed position in the cubicle 10. In Figure 6 it is shown complete, and in Figure 7 with three of the leaves removed.

In this arrangement, the baffle 50 comprises a number of parrallel planar plates 52, 53, 54, 55, The rearmost leaf 55 also includes two detents 58a, 58b, of suitable position and size to engage with the catches 28a, 28b securing the mesh grille 27 to the filter housing 26 in the door 10 of the cubicle 1, as best shown in Figure 7. The leaves 52, 53, 54, 55 are connected to each other by frangible webs 56, 57, 59.

It will be noted that the respective connections 56,57,59 between each leaf and the one behind it are depicted as increasing in size and number from front to rear. This assists an operator in removing only one leaf at a time, as the weakest connection will always be between the two foremost remaining leaves.

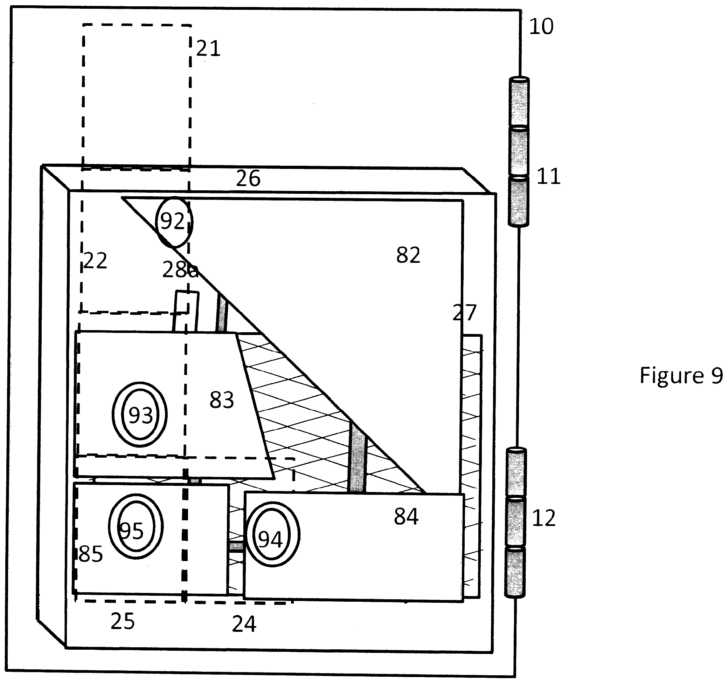

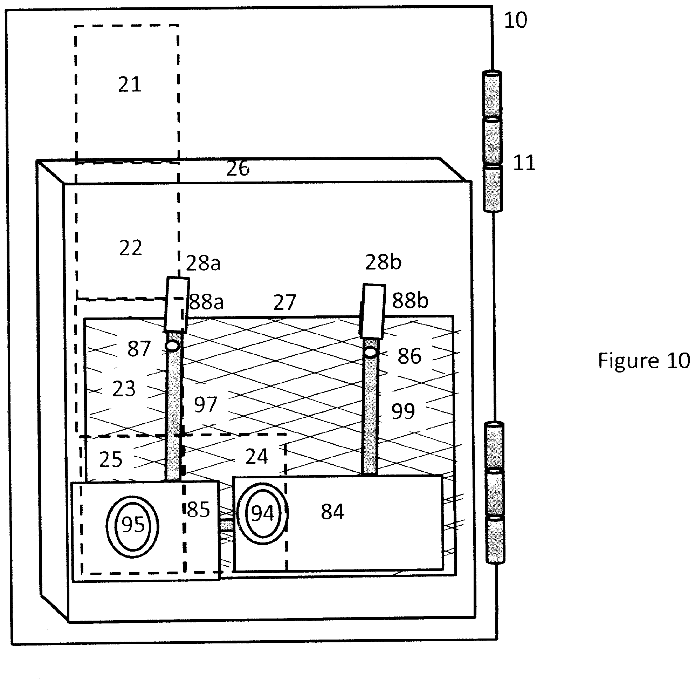

Figure 8 depicts a third design of baffle, which is shown in Figure 9 and Figure 10 in its installed position in the cubicle 10. In Figure 9 it is shown complete, and in Figure 10 with two of its leaves removed.

In this arrangement, the baffle plate 80 comprises a number of planar plates 82, 83, 84, 85. Each plate comprises a projection 92, 93, 94, 95 arranged such that, when the plate 80 is installed in the cubicle door 1 and the door is closed, each projection extends into the space intended for a respective one of the line cards 22, 23, 24, 25 (shown dotted in Figures 9 and 10). Thus, when a technician installs a new line card (e.g 22), the corresponding leaf (e.g. 82) of the baffle plate has to be removed in order to allow the door to be closed.

As in the other embodiments, the leaves 82, 83, 84, 85 are connected together by frangible webs 86, 87, 89. The leaves 84, 85 that are to be removed last are also connected to two detents 88a, 88b, of suitable position and size to engage with the catches 88a, 88b securing the mesh grille 27 to the filter housing 26 in the door 10 of the cubicle 1, as best shown in Figure 10. As best shown in Figure 10, the webs 87, 89 also incorporate spacers 97, 99 to position the leaves 84, 85 and the detents 88a, 88b in the correct positions relative to the ventilation system 26, 27 etc the repective line cards 24, 25.

It should be understood that the equipment cubicle 1 depicted in the figures is used purely for illustration, and the actual configurations of the baffles 30, 50, 80 depicted in the Figures are designed around that design of cubicle. The design of the baffle can be adapted to accomodate different internal layouts and dimensions of cabinet without departing from the scope of the claims and, in particular, details such as the fixing means, and the number, sizes and dimensions of the leaves are not limited to those depicted in these embodiments.

The connections between the leaves of the baffle may take any suitable form. In this embodiment, they take the form of frangible webs, so that the leaves are removed permanently, allowing the entire baffle 30, 40, 50, 80 to be made as one integral component, for example by injection moulding. However, the leaves may be designed to be removed by some other method. In particular, if it is envisaged that the capability may be required to reinstate leaves to the baffle, for example to provide for the possibility that a line card might be decommissioned at some time, then a less permanent method of removal may be used.

## Claims

1. A method for controlling the ventilation characteristics of an equipment cubicle, the cubicle (1) comprising a housing enclosing an interior space, and the housing having one or more apertures (13) for ventilation of the interior space, wherein the interior space of the cabinet has provision for installation of a plurality of electrical components (21, 22, 23, 24, 25),
**characterised in that** the method comprises the installation, within the cubicle, of a baffle (30) comprising a plurality of detachable leaves (32, 33, 34, 35) masking at least a part of the apertures, and wherein a number of leaves are detached from the baffle in accordance with the number of electrical components installed.

2. A method according to claim 1, wherein the detachable leaves are connected to each other by frangible webs (36, 37, 39).

3. A method as claimed in claim 2, wherein the frangible webs have different breaking strengths, such that the leaves can be removed in a predetermined order according to increasing breaking strength of the webs connecting them.

4. A method according to any preceding claim, in which the number of leaves in the baffle plate 30 is one less than the maxiumum number of electrical components that can be fitted in the cubicle, and in which the complete baffle is installed if only one of the electrical components is installed, and one leaf is then removed for each additional electrical component

5. A method according to any preceding claim, wherein the leaves (82, 83, 84, 85) and the electrical components (21, 22, 23, 24, 25) at least partially occupy the same volume of the interior space, such that each leaf has to be removed to allow the installation of a corresponding electrical component.

6. A method according to any preceding claim, wherein at least some of the leaves (32, 33, 34, 35) are arranged in a coplanar configuration.

7. A method according to any preceding claim, wherein at least some of the leaves (52, 53, 54, 55) are arranged to overlie each other.

8. A method according to any preceding claim, wherein the baffle further comprises means (38a, 38b) for securing it to an interior component (17) of the equipment cubicle.

## Patentansprüche

1. Verfahren zum Steuern der Belüftungseigenschaften eines Schaltschranks, wobei der Schrank (1) ein Gehäuse umfasst, das einen Innenraum einschließt, und das Gehäuse eine oder mehrere Öffnungen (13) zum Belüften des Innenraums aufweist, wobei der Innenraum des Kastens Vorbereitungen für eine Installation mehrerer elektrischer Komponenten (21, 22, 23, 24, 25) aufweist,
**dadurch gekennzeichnet, dass** das Verfahren die Installation eines Leitblechs (30) in dem Schrank umfasst, das mehrere abnehmbare Blenden (32, 33, 34, 35) aufweist, die zumindest einen Teil der Öffnungen abdecken, und wobei eine Anzahl von Blenden von dem Leitblech abgenommen wird, die der Anzahl installierter elektrischer Komponenten entspricht.

2. Verfahren nach Anspruch 1, wobei die abnehmbaren Blenden durch zerbrechbare Rippen (36, 37, 39) miteinander verbunden sind.

3. Verfahren nach Anspruch 2, wobei die zerbrechbaren Rippen unterschiedliche Bruchfestigkeiten aufweisen, sodass die Blenden entsprechend einer sich erhöhenden Bruchfestigkeit der sie verbindenden Rippen in einer vorbestimmten Reihenfolge entfernt werden können.

4. Verfahren nach einem der vorhergehenden Ansprüche, wobei die Anzahl von Blenden in dem Leitblech (30) eine weniger als die maximale Anzahl von elektrischen Komponenten ist, die in dem Schrank eingebaut werden können, und wobei das komplette Leitblech installiert wird, wenn nur eine der elektrischen Komponenten installiert wird, und dann eine Blende für jede zusätzliche elektrische Komponente entfernt wird.

5. Verfahren nach einem der vorhergehenden Ansprüche, wobei die Blenden (82, 83, 84, 85) und die elektrischen Komponenten (21, 22, 23, 24, 25) zumindest teilweise dasselbe Volumen des Innenraums einnehmen, sodass jede Blende entfernt werden muss, um die Installation einer entsprechenden elektrischen Komponente zu ermöglichen.

6. Verfahren nach einem der vorhergehenden Ansprüche, wobei zumindest einige der Blenden (32, 33, 34, 35) in einer koplanaren Ausgestaltung angeordnet sind.

7. Verfahren nach einem der vorhergehenden Ansprüche, wobei zumindest einige der Blenden (52, 53, 54, 55) einander überlagernd angeordnet sind.

8. Verfahren nach einem der vorhergehenden Ansprüche, wobei das Leitblech ferner Mittel (38a, 38b) zum Sichern desselben an einer internen Komponente (17) des Schaltschranks umfasst.

## Revendications

1. Procédé pour commander les caractéristiques de ventilations d'une armoire d'équipement, l'armoire (1) comprenant un logement enfermant un espace intérieur, et le logement ayant une ou plusieurs ouvertures (13) pour la ventilation de l'espace intérieur, dans lequel l'espace intérieur de l'armoire a des dispositions pour l'installation d'une pluralité de composants électriques (21, 22, 23, 24, 25),
**caractérisé en ce que** le procédé comprend l'installation, à l'intérieur de l'armoire, d'un déflecteur (30) comprenant une pluralité de volets détachables (32, 33, 34, 35) masquant au moins une partie des ouvertures, et dans lequel un nombre de volets sont détachés du déflecteur conformément au nombre de composants électriques installés.

2. Procédé selon la revendication 1, dans lequel les volets détachables sont raccordés les uns aux autres par des bandes cassantes (36, 37, 39).

3. Procédé selon la revendication 2, dans lequel les bandes cassantes ont différentes résistances à la rupture, de telle sorte que les volets puissent être enlevés dans un ordre prédéterminé selon une résistance à la rupture croissante des bandes les raccordant.

4. Procédé selon une quelconque revendication précédente, dans lequel le nombre de volets dans la plaque de déflecteur (30) est un de moins que le nombre maximum de composants électriques qui peuvent être placés dans l'armoire, et dans lequel le déflecteur complet est installé si seulement un des composants électriques est installé, et un volet est alors enlevé pour chaque composant électrique supplémentaire.

5. Procédé selon une quelconque revendication précédente, dans lequel les volets (82, 83, 84, 85) et les composants électriques (21, 22, 23, 24, 25) occupant au moins partiellement le même volume de l'espace intérieur, de telle sorte que chaque volet doive être enlevé pour permettre l'installation d'un composant électrique correspondant.

6. Procédé selon une quelconque revendication précédente, dans lequel au moins certains des volets (32, 33, 34, 35) sont agencés dans une configuration coplanaire.

7. Procédé selon une quelconque revendication précédente, dans lequel au moins certains des volets (52, 53, 54, 55) sont agencés pour se recouvrir.

8. Procédé selon une quelconque revendication précédente, dans lequel le déflecteur comprend en outre des moyens (38a, 38b) pour le fixer à un composant intérieur (17) de l'armoire d'équipement.
